# EUROPÄISCHE PATENTSCHRIFT

(11) **EP 3 903 394 B1**
(45) Veröffentlichungstag und Bekanntmachung des Hinweises auf die Patenterteilung: **29.03.2023**
(21) Anmeldenummer: 19727292.5
(22) Anmeldetag: 07.05.2019
(51) Int. Cl.: H03K 17/687, H03K 17/0814, H03K 17/693, H02H 3/087

(54) **VERBINDEN EINER LAST MIT EINEM GLEICHSTROMNETZ**
CONNECTING A LOAD TO A DIRECT CURRENT NETWORK
RELIER UNE CHARGE À UN RÉSEAU À COURANT CONTINU

(30) Priorität: 31.01.2019 EP 19154727
(43) Veröffentlichungstag der Anmeldung: 03.11.2021
(73) Patentinhaber: Siemens Aktiengesellschaft, 80333 München (DE)
(72) Erfinder: HANDT, Karsten, 92348 Berg (DE)
(74) Vertreter: Siemens Patent Attorneys
(86) Internationale Anmeldenummer: PCT/EP2019/061668
(87) Internationale Veröffentlichungsnummer: WO 2020/156688

(56) Entgegenhaltungen:
- EP-A2- 2 814 157
- DE-A1- 10 212 164
- DE-A1-102014 225 431
- DE-A1-102016 204 400
- US-A1- 2016 365 854
- US-B2- 9 065 326

## Beschreibung

Die Erfindung betrifft ein Verfahren zum Verbinden einer Last mit einem Gleichstromnetz.

In einem Gleichstromnetz kann zwischen zwei Typen von mit dem Gleichstromnetz verbundenen Lasten unterschieden werden. Zum einen gibt es Lasten eines ersten Typs, bei dem ein elektrischer Strom immer in derselben Stromrichtung durch eine Verbindungsleitung zwischen dem Gleichstromnetz und der Last fließt. Derartige Lasten sind beispielsweise reine Verbraucher, denen durch das Gleichstromnetz Energie zugeführt wird. Zum anderen gibt es Lasten eines zweiten Typs, bei dem ein elektrischer Strom in beiden Stromrichtungen durch eine Verbindungsleitung zwischen dem Gleichstromnetz und der Last fließen kann. Derartige Lasten können mit Energie aus dem Gleichstromnetz versorgt werden und Energie an das Gleichstromnetz abgeben. Ein Beispiel für eine Last des zweiten Typs ist eine rotierende elektrische Maschine, die sowohl als Elektromotor als auch als Generator betrieben werden oder wirken kann. Während Lasten des ersten Typs vor Überströmen nur einer Stromrichtung geschützt werden müssen, müssen Lasten des zweiten Typs vor Überströmen beider Stromrichtungen geschützt werden. Häufig ist es erforderlich, Überströme, die beispielsweise durch Überlastungen oder Kurzschlüsse verursacht werden, sehr schnell abschalten zu können, um Schäden zu vermeiden oder zu reduzieren. Dazu werden in der Regel elektronische Schalter verwendet.

Aus der DE10212164A1 ist ein System zur Versorgung einer Last mittels zweier Leistungsversorgungen bekannt, die mittels zweier als MOSFET ausgebildeter Isolationsschalter die Last selektiv speisen und so angesteuert werden, dass nur die eine oder die andere der Leistungsversorgungen die Last zu einem beliebigen Zeitpunkt bei Normalbetrieb mit Leistung versorgt. Dazu wird insbesondere ein Rückwärtsstrom im Isolationsschalter überwacht und der Isolationsschalter ausgeschaltet, wenn ein Rückwärtsstrom detektiert wird.

Aus der DE102014225431A1 ist eine ähnliche Schaltung mit zur Trennung und Verbindung zweier Teilbordnetze eines Fahrzeugs bekannt. Die Schaltung umfasst zwei in Reihe geschaltete Schaltelemente und ein Steuergerät, wobei das Steuergerät derart ausgebildet ist, dass dieses in Abhängigkeit von erfassten Ist-Werten und vorab festgelegten Soll-Werten der Teilbordnetze Steuersignale für die Schaltelemente erzeugt, so dass mittels der Schaltelemente beispielsweise aus einer an einem Anschlusspunkt eingespeisten Spannung verschiedene Spannungen an den Teilbordnetzen bereitgestellt werden können.

Aus der EP2814157A2 ist eine Schaltung bekannt, die dem Anschluss eines elektrischen Speichers an eine Spannungsquelle dient. Diese Schaltung weist in einem Pfad zwischen elektrischem Speicher und Spannungsquelle eine Serienschaltung zweier jeweils durch eine Diode überbrückter Halbleiterschalter auf, welche durch eine Steuerung gesteuert werden. Dabei wird die Versorgungsspannung für die Steuerung am gemeinsamen Punkt zwischen den beiden Halbleiterschaltern abgegriffen.

Der Erfindung liegt die Aufgabe zugrunde, ein Verfahren anzugeben, mit denen Verbindungen von Lasten beider eingangs genannter Typen mit einem Gleichstromnetz geeignet vor Überströmen geschützt werden können.

Die Aufgabe wird erfindungsgemäß durch ein Verfahren mit den Merkmalen des Anspruchs 1 gelöst.

Vorteilhafte Ausgestaltungen der Erfindung sind Gegenstand der Unteransprüche.

Das erfindungsgemäße Verfahren betrifft das Verbinden einer Last mit einem Gleichstromnetz mittels eines Schaltmoduls, das einen ersten Modulanschluss, einen zweiten Modulanschluss, einen dritten Modulanschluss, einen ersten elektronischen Schalter und einen zweiten elektronischen Schalter aufweist. Der erste elektronische Schalter ist zwischen den ersten Modulanschluss und den zweiten Modulanschluss geschaltet. Der zweite elektronische Schalter ist zwischen den zweiten Modulanschluss und den dritten Modulanschluss geschaltet. Ferner sind die beiden elektronischen Schalter antiseriell, das heißt mit einander entgegengesetzten Durchlassrichtungen, zwischen den ersten Modulanschluss und den dritten Modulanschluss geschaltet. Unter den Begriff einer Last wird hier und im Folgenden auch eine Lastzone mit mehreren Geräten gefasst.

Das erfindungsgemäße Verfahren ermöglicht es, eine Last mit einem Gleichstromnetz auf verschiedene Weisen in Abhängigkeit davon zu verbinden, ob zwischen der Last und dem Gleichstromnetz ein bidirektionaler Überstromschutz vor Überströmen in beiden Stromrichtungen oder nur ein unidirektionaler Überstromschutz vor Überströmen mit einer Stromrichtung benötigt wird.

Für den bidirektionalen Überstromschutz weist das Schaltmodul den ersten Modulanschluss und den dritten Modulanschluss auf. Die antiserielle Verschaltung der beiden elektronischen Schalter zwischen diesen beiden Modulanschlüssen ermöglicht einen Überstromschutz in beiden Stromrichtungen durch Öffnen des elektronischen Schalters, dessen Durchlassrichtung der jeweiligen Stromrichtung des Überstroms entspricht. Eine bidirektional vor Überströmen zu schützende Last wird daher über den ersten Modulanschluss und den dritten Modulanschluss mit dem Gleichstromnetz verbunden, wobei der erste Modulanschluss mit dem Gleichstromnetz verbunden wird und der dritte Modulanschluss mit der Last verbunden wird und der zweite Modulanschluss unbeschaltet bleibt.

Für den unidirektionalen Überstromschutz weist das Schaltmodul den zweiten Modulanschluss auf, der über den ersten elektronischen Schalter mit dem ersten Modulanschluss und über den zweiten elektronischen Schalter mit dem dritten Modulanschluss verbunden ist. Dies ermöglicht, eine nur unidirektional vor Überströmen zu schützende Last beispielsweise über den zweiten Modulanschluss als lastseitigen Anschluss und über den ersten und/oder den dritten Modulanschluss als netzseitigen Anschluss mit dem Gleichstromnetz zu verbinden. Dadurch muss der Strom zwischen der Last und dem Gleichstromnetz nur über einen der beiden elektronischen Schalter fließen, wodurch die Verluste gegenüber einer Stromführung über beide in Reihe geschaltete Schalter vorteilhaft halbiert werden. Ferner können auch der erste Modulanschluss und der dritte Modulanschluss zusammengeschaltet und mit dem Gleichstromnetz verbunden werden, während der zweite Modulanschluss mit der Last verbunden wird. Dann sind die beiden elektronischen Schalter parallelgeschaltet und die Verluste werden noch einmal reduziert.

Bei einer Ausgestaltung der Erfindung ist jeder elektronische Schalter ein Bipolartransistor mit isolierter Gate-Elektrode (IGBT = Insulated-Gate Bipolar Transistor), der einen Kollektor-Anschluss, einen Emitter-Anschluss und einen Gate-Anschluss aufweist. Dabei ist beispielsweise der Kollektor-Anschluss des ersten elektronischen Schalters mit dem ersten Modulanschluss verbunden, der Kollektor-Anschluss des zweiten elektronischen Schalters ist mit dem dritten Modulanschluss verbunden, und die Emitter-Anschlüsse der elektronischen Schalter sind miteinander und jeweils mit dem zweiten Modulanschluss verbunden. Alternativ ist der Emitter-Anschluss des ersten elektronischen Schalters mit dem ersten Modulanschluss verbunden, der Emitter-Anschluss des zweiten elektronischen Schalters ist mit dem dritten Modulanschluss verbunden, und die Kollektor-Anschlüsse der elektronischen Schalter sind miteinander und jeweils mit dem zweiten Modulanschluss verbunden. Die Schaltungsvariante, bei der die Emitter-Anschlüsse der elektronischen Schalter miteinander und jeweils mit dem zweiten Modulanschluss verbunden sind, hat den Vorteil, dass für beide Gate-Anschlüsse dieselbe Steuerspannung verwendet und daher ein Gate-Treiber eingespart werden kann. Die Schaltungsvariante, bei der die Kollektor-Anschlüsse der elektronischen Schalter miteinander und jeweils mit dem zweiten Modulanschluss verbunden sind, hat den Vorteil einer höheren Stabilität gegenüber netzgeführten elektromagnetischen Störungen. Welcher Vorteil überwiegt und welche Schaltungsvariante daher bevorzugt verwendet wird, hängt von der konkreten Anwendung ab.

Bei einer anderen Ausgestaltung der Erfindung ist jeder elektronische Schalter ein Metall-Oxid-Halbleiter-Feldeffekttransistor (MOSFET = Metal-Oxide-Semiconductor Field-Effect Transistor) mit einem Drain-Anschluss, einem Source-Anschluss und einem Gate-Anschluss. Dabei ist beispielsweise der Drain-Anschluss des ersten elektronischen Schalters mit dem ersten Modulanschluss verbunden, der Drain-Anschluss des zweiten elektronischen Schalters ist mit dem dritten Modulanschluss verbunden, und die Source-Anschlüsse der elektronischen Schalter sind miteinander und jeweils mit dem zweiten Modulanschluss verbunden. Alternativ ist der Source-Anschluss des ersten elektronischen Schalters mit dem ersten Modulanschluss verbunden, der Source-Anschluss des zweiten elektronischen Schalters ist mit dem dritten Modulanschluss verbunden, und die Drain-Anschlüsse der elektronischen Schalter sind miteinander und jeweils mit dem zweiten Modulanschluss verbunden. Die vorgenannten Schaltungsvarianten entsprechen den oben genannten im Fall, dass die elektronischen Schalter IGBT sind, wobei der Drain-Anschluss eines MOSFET die Rolle des Kollektor-Anschlusses des entsprechenden IGBT und der Source-Anschluss des MOSFET die Rolle des Emitter-Anschlusses des IGBT übernimmt.

Bei einer weiteren Ausgestaltung der Erfindung ist antiparallel zu jedem elektronischen Schalter eine Diode geschaltet. Dadurch wird beispielsweise im Fall eines als IGBT ausgebildeten elektronischen Schalters eine Stromführung durch die Diode in der Sperrrichtung des IGBT ermöglicht. Auch im Fall eines als MOSFET ausgebildeten elektronischen Schalters kann eine antiparallel zu dem MOSFET geschaltete Diode vorteilhaft sein, beispielsweise wenn eine Flussspannung an der Inversdiode des MOSFET zu groß wird.

Es ist möglich, am Schaltmodul Anschlussbezeichnungen für die Modulanschlüsse vorzusehen, die den ersten Modulanschluss als einen unidirektionalen und bidirektionalen Eingangsanschluss, den zweiten Modulanschluss als einen unidirektionalen Ausgangsanschluss und den dritten Modulanschluss als einen unidirektionalen Eingangsanschluss und bidirektionalen Ausgangsanschluss ausweisen. Diese Anschlussbezeichnungen erleichtern vorteilhaft eine dem jeweils erwünschten Überstromschutz (bi- oder unidirektional) angepasste Beschaltung des Schaltmoduls und reduzieren die Gefahr fehlerhafter oder ungünstiger Beschaltungen.

Bei einer weiteren Ausgestaltung der Erfindung sind der erste Modulanschluss und der dritte Modulanschluss über einen Schalter miteinander verbindbar. Dies vereinfacht die oben bereits erwähnte vorteilhafte Parallelschaltung der beiden elektronischen Schalter im Falle einer nur unidirektional vor Überstrom zu schützenden Last, da diese Parallelschaltung durch Schließen des Schalters möglich ist.

Bei dem erfindungsgemäßen Verfahren zum Verbinden einer Last mit einem Gleichstromnetz mittels eines wie vorstehend beschriebenen Schaltmoduls wird, wenn zwischen der Last und dem Gleichstromnetz ein bidirektionaler Überstromschutz vor Überströmen in beiden Stromrichtungen benötigt wird, eine Netzleitung des Gleichstromnetzes mit dem ersten Modulanschluss des Schaltmoduls verbunden und eine Lastleitung der Last wird mit dem dritten Modulanschluss des Schaltmoduls verbunden. Der zweite Modulanschluss bleibt unbeschaltet.

Wenn hingegen zwischen der Last und dem Gleichstromnetz nur ein unidirektionaler Überstromschutz vor Überströmen mit einer Stromrichtung benötigt wird, wird eine Netzleitung des Gleichstromnetzes mit dem ersten Modulanschluss und/oder dem dritten Modulanschluss des Schaltmoduls verbunden und eine Lastleitung der Last wird mit dem zweiten Modulanschluss des Schaltmoduls verbunden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines ersten Schaltmoduls zur Verwendung im Zusammenhang mit einem ersten Ausführungsbeispiel der vorliegenden Erfindung,
- FIG 2: einen Schaltplan eines zweiten Schaltmoduls zur Verwendung im Zusammenhang mit einem zweiten Ausführungsbeispiel der vorliegenden Erfindung,
- FIG 3: einen Schaltplan eines dritten Schaltmoduls zur Verwendung im Zusammenhang mit einem dritten Ausführungsbeispiel der vorliegenden Erfindung,
- FIG 4: einen Schaltplan eines vierten Schaltmoduls zur Verwendung im Zusammenhang mit einem vierten Ausführungsbeispiel der vorliegenden Erfindung,
- FIG 5: einen Schaltplan eines fünften Schaltmoduls zur Verwendung im Zusammenhang mit einem fünften Ausführungsbeispiel der vorliegenden Erfindung,
- FIG 6: schematisch eine über ein Schaltmodul mit einem Gleichstromnetz für bidirektionalen Überstromschutz verbundene Last,
- FIG 7: schematisch eine über ein Schaltmodul mit einem Gleichstromnetz für unidirektionalen Überstromschutz verbundene Last.

Einander entsprechende Teile sind in den Figuren mit denselben Bezugszeichen versehen.

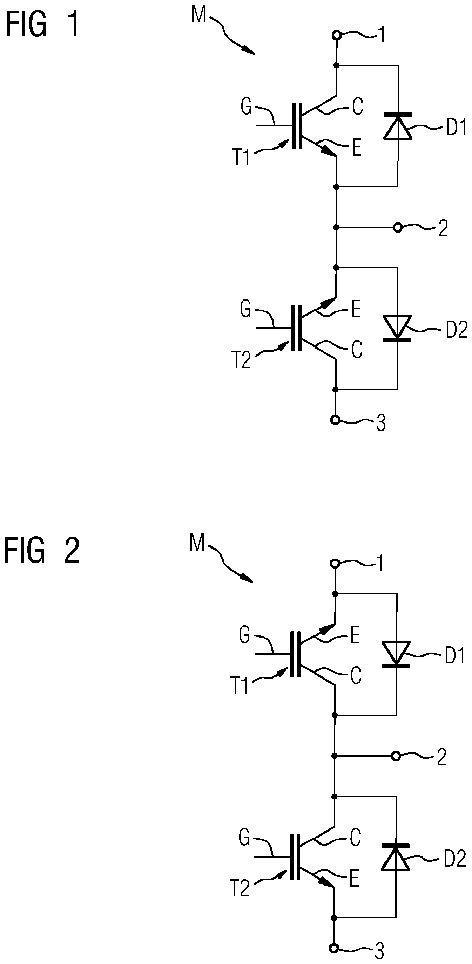

Figur 1 zeigt einen Schaltplan eines ersten Schaltmoduls M. Das Schaltmodul M umfasst einen ersten Modulanschluss 1, einen zweiten Modulanschluss 2, einen dritten Modulanschluss 3, einen ersten elektronischen Schalter T1, einen zweiten elektronischen Schalter T2, eine erste Diode D1 und eine zweite Diode D2.

Jeder elektronische Schalter T1, T2 ist ein IGBT mit einem Kollektor-Anschluss C, einem Emitter-Anschluss E und einem Gate-Anschluss G.

Der Kollektor-Anschluss C des ersten elektronischen Schalters T1 ist mit dem ersten Modulanschluss 1 verbunden. Der Kollektor-Anschluss C des zweiten elektronischen Schalters T2 ist mit dem dritten Modulanschluss 3 verbunden. Die Emitter-Anschlüsse E der elektronischen Schalter T1, T2 sind miteinander und jeweils mit dem zweiten Modulanschluss 2 verbunden. Damit ist der erste elektronische Schalter T1 zwischen den ersten Modulanschluss 1 und den zweiten Modulanschluss 2 geschaltet, der zweite elektronische Schalter T2 ist zwischen den zweiten Modulanschluss 2 und den dritten Modulanschluss 3 geschaltet, und die beiden elektronischen Schalter T1, T2 sind antiseriell zwischen den ersten Modulanschluss 1 und den dritten Modulanschluss 3 geschaltet.

Die Kathode der ersten Diode D1 ist mit dem Kollektor-Anschluss C des ersten elektronischen Schalters T1 verbunden. Die Anode der ersten Diode D1 ist mit dem Emitter-Anschluss E des ersten elektronischen Schalters T1 verbunden. Dadurch ist die erste Diode D1 antiparallel zu dem ersten elektronischen Schalter T1 geschaltet.

Die Kathode der zweiten Diode D2 ist mit dem Kollektor-Anschluss C des zweiten elektronischen Schalters T2 verbunden. Die Anode der zweiten Diode D2 ist mit dem Emitter-Anschluss E des zweiten elektronischen Schalters T2 verbunden. Dadurch ist die zweite Diode D2 antiparallel zu dem zweiten elektronischen Schalter T2 geschaltet.

Figur 2 zeigt einen Schaltplan eines zweiten Schaltmoduls M. Dieses unterscheidet sich von dem in Figur 1 dargestellten ersten Modul lediglich dadurch, dass die Verschaltungen der Kollektor-Anschlüsse C und der Emitter-Anschlüsse E der elektronischen Schalter T1, T2 gegenüber dem ersten Ausführungsbeispiel vertauscht sind: der Emitter-Anschluss E des ersten elektronischen Schalters T1 ist mit dem ersten Modulanschluss 1 verbunden, der Emitter-Anschluss E des zweiten elektronischen Schalters T2 ist mit dem dritten Modulanschluss 3 verbunden, und die Kollektor-Anschlüsse C der elektronischen Schalter T1, T2 sind miteinander und jeweils mit dem zweiten Modulanschluss 2 verbunden. Wiederum ist die erste Diode D1 antiparallel zu dem ersten elektronischen Schalter T1 geschaltet und die zweite Diode D2 ist antiparallel zu dem zweiten elektronischen Schalter T2 geschaltet.

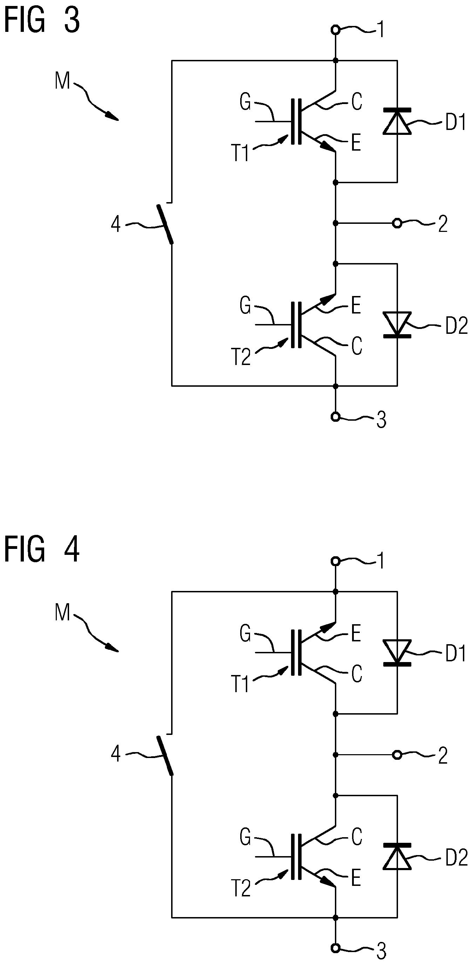

Figur 3 zeigt einen Schaltplan eines dritten Schaltmoduls M. Dieses Modul unterscheidet sich von dem in Figur 1 dargestellten ersten Modul lediglich durch einen zusätzlichen Schalter 4, der zwischen den ersten Modulanschluss 1 und den dritten Modulanschluss 3 geschaltet ist, so dass durch Schließen des Schalters 4 der erste Modulanschluss 1 und der dritte Modulanschluss 3 miteinander verbunden werden können. Dadurch können die beiden elektronischen Schalter T1, T2 durch Schließen des Schalters 4 parallel zueinander zwischen den ersten Modulanschluss 1 oder den dritten Modulanschluss 3 und den zweiten Modulanschluss 2 geschaltet werden.

Figur 4 zeigt einen Schaltplan eines vierten Schaltmoduls M. Dieses Modul unterscheidet sich von dem in Figur 2 dargestellten zweiten Modul lediglich durch einen zusätzlichen Schalter 4, der zwischen den ersten Modulanschluss 1 und den dritten Modulanschluss 3 geschaltet ist, so dass durch Schließen des Schalters 4 analog zu Figur 3 der erste Modulanschluss 1 und der dritte Modulanschluss 3 miteinander verbunden werden können.

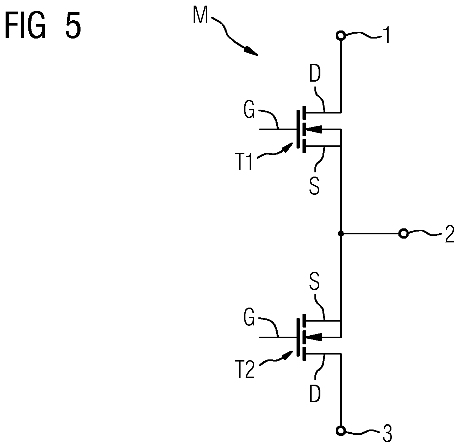

Figur 5 zeigt einen Schaltplan eines fünften Schaltmoduls M. Dieses Modul unterscheidet sich von dem in Figur 1 dargestellten ersten Modul im Wesentlichen dadurch, dass jeder elektronische Schalter T1, T2 ein MOSFET mit einem Drain-Anschluss D, einem Source-Anschluss S und einem Gate-Anschluss G ist, wobei der Drain-Anschluss D die Rolle des Kollektor-Anschlusses C des entsprechenden IGBT in Figur 1 und der Source-Anschluss S die Rolle des Emitter-Anschlusses E des IGBT übernimmt. Außerdem weist das in Figur 5 gezeigte Schaltmodul M keine Dioden D1, D2 auf, beziehungsweise die Funktion der in Figur 1 gezeigten Dioden D1, D2 wird in dem in Figur 5 gezeigten Ausführungsbeispiel von den (intrinsischen) Inversdioden der als MOSFET ausgebildeten elektronischen Schalter T1, T2 übernommen. Erforderlichenfalls, insbesondere wenn Flussspannungen an den Inversdioden zu groß werden, kann das in Figur 5 gezeigte Ausführungsbeispiel jedoch analog zu dem in Figur 1 gezeigten Ausführungsbeispiel abgewandelt werden, indem eine Diode D1, D2 antiparallel zu jedem elektronischen Schalter T1, T2 geschaltet ist.

Analog zu der Abwandlung des in Figur 1 gezeigten Moduls zu dem in Figur 5 gezeigten Modul können auch die in den Figuren 2 bis 4 gezeigten Module abgewandelt werden, indem jeweils jeder als ein IGBT ausgebildete elektronische Schalter T1, T2 durch einen als ein MOSFET ausgebildeten elektronischen Schalter T1, T2 ohne oder mit dazu antiparallel geschalteter Diode D1, D2 ersetzt wird, wobei der Drain-Anschluss D des MOSFET wie der Kollektor-Anschluss C des IGBT verschaltet ist und der Source-Anschluss S des MOSFET wie der Emitter-Anschluss E des IGBT verschaltet ist.

Entsprechend können die in den Figuren 1 bis 4 gezeigten Module jeweils abgewandelt werden, indem jeder als ein IGBT ausgebildete elektronische Schalter T1, T2 durch einen anderen Halbleiterschalter als einen MOSFET ersetzt wird.

Die in den Figuren 1 und 5 gezeigten Schaltmodule M und deren oben beschriebene Abwandlungen sind dazu ausgebildet, eine Last L mit einem Gleichstromnetz N zu verbinden und die Verbindung vor Überströmen zu schützen, indem im Fall eines Überstroms der jeweilige elektronische Schalter T1, T2, über den der Überstrom fließt, geöffnet wird. Dazu sind die Modulanschlüsse 1, 2, 3 jeweils aus dem Schaltmodul M herausgeführt.

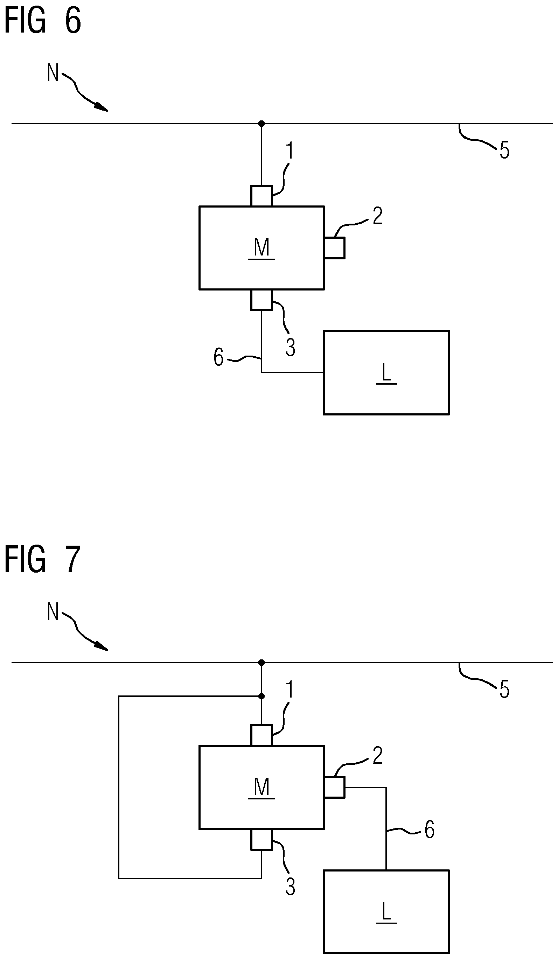

Figur 6 zeigt schematisch den Fall, dass zwischen der Last L und dem Gleichstromnetz N ein bidirektionaler Überstromschutz vor Überströmen in beiden Stromrichtungen benötigt wird. In diesem Fall wird bei allen beschriebenen Varianten des Schaltmoduls M eine Netzleitung 5 des Gleichstromnetzes N mit dem ersten Modulanschluss 1 des Schaltmoduls M verbunden und eine Lastleitung 6 der Last L wird mit dem dritten Modulanschluss 3 des Schaltmoduls M verbunden.

Figur 7 zeigt schematisch den Fall, dass zwischen der Last L und dem Gleichstromnetz N nur ein unidirektionaler Überstromschutz vor Überströmen mit einer Stromrichtung benötigt wird. In diesem Fall wird die Lastleitung 6 der Last L mit dem zweiten Modulanschluss 2 des Schaltmoduls M verbunden und die Netzleitung 5 des Gleichstromnetzes N wird mit dem ersten Modulanschluss 1 und dem dritten Modulanschluss 3 verbunden. Alternativ kann die Netzleitung 5 des Gleichstromnetzes N in diesem Fall auch nur mit dem ersten Modulanschluss 1 oder dem dritten Modulanschluss 3 verbunden werden. Im Fall der in den Figuren 3 und 4 gezeigten Module kann dabei der Schalter 4 geschlossen werden.

Vorzugsweise weist das Schaltmodul M jeweils Anschlussbezeichnungen für die Modulanschlüsse 1, 2, 3 auf, die den ersten Modulanschluss 1 als einen unidirektionalen und bidirektionalen Eingangsanschluss, den zweiten Modulanschluss 2 als einen unidirektionalen Ausgangsanschluss und den dritten Modulanschluss 3 als einen unidirektionalen Eingangsanschluss und bidirektionalen Ausgangsanschluss ausweisen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Verbinden einer Last (L) mit einem Gleichstromnetz (N) mittels eines Schaltmoduls (M), das Schaltmodul (M) umfassend einen ersten Modulanschluss (1), einen zweiten Modulanschluss (2) und einen dritten Modulanschluss (3) sowie
- einen ersten elektronischen Schalter (T1), der zwischen den ersten Modulanschluss (1) und den zweiten Modulanschluss (2) geschaltet ist, und
- einen zweiten elektronischen Schalter (T2), der zwischen den zweiten Modulanschluss (2) und den dritten Modulanschluss (3) geschaltet ist, wobei
- die beiden elektronischen Schalter (T1, T2) antiseriell zwischen den ersten Modulanschluss (1) und den dritten Modulanschluss (3) geschaltet sind, wobei
- wenn zwischen der Last (L) und dem Gleichstromnetz (N) ein bidirektionaler Überstromschutz vor Überströmen in beiden Stromrichtungen benötigt wird, eine Netzleitung (5) des Gleichstromnetzes (N) mit dem ersten Modulanschluss (1) des Schaltmoduls (M) verbunden wird und eine Lastleitung (6) der Last (L) mit dem dritten Modulanschluss (3) des Schaltmoduls (M) verbunden wird und der zweite Modulanschluss (2) unbeschaltet bleibt,
und wobei
- wenn zwischen der Last (L) und dem Gleichstromnetz (N) nur ein unidirektionaler Überstromschutz vor Überströmen mit einer Stromrichtung benötigt wird, eine Netzleitung (5) des Gleichstromnetzes (N) mit dem ersten Modulanschluss (1) und/oder dem dritten Modulanschluss (3) des Schaltmoduls (M) verbunden wird und eine Lastleitung (6) der Last (L) mit dem zweiten Modulanschluss (2) des Schaltmoduls (M) verbunden wird.

2. Verfahren nach Anspruch 1, wobei jeder elektronische Schalter (T1, T2) ein Bipolartransistor mit isolierter Gate-Elektrode ist, der einen Kollektor-Anschluss (C), einen Emitter-Anschluss (E) und einen Gate-Anschluss (G) aufweist.

3. Verfahren nach Anspruch 2, wobei der Kollektor-Anschluss (C) des ersten elektronischen Schalters (T1) mit dem ersten Modulanschluss (1) verbunden ist, der Kollektor-Anschluss (C) des zweiten elektronischen Schalters (T2) mit dem dritten Modulanschluss (3) verbunden ist und die Emitter-Anschlüsse (E) der elektronischen Schalter (T1, T2) miteinander und jeweils mit dem zweiten Modulanschluss (2) verbunden sind.

4. Verfahren nach Anspruch 2, wobei der Emitter-Anschluss (E) des ersten elektronischen Schalters (T1) mit dem ersten Modulanschluss (1) verbunden ist, der Emitter-Anschluss (E) des zweiten elektronischen Schalters (T2) mit dem dritten Modulanschluss (3) verbunden ist und die Kollektor-Anschlüsse (C) der elektronischen Schalter (T1, T2) miteinander und jeweils mit dem zweiten Modulanschluss (2) verbunden sind.

5. Verfahren nach Anspruch 1, wobei jeder elektronische Schalter (T1, T2) ein Metall-Oxid-Halbleiter-Feldeffekttransistor ist, der einen Drain-Anschluss (D), einen Source-Anschluss (S) und einen Gate-Anschluss (G) aufweist.

6. Verfahren nach Anspruch 5, wobei der Drain-Anschluss (D) des ersten elektronischen Schalters (T1) mit dem ersten Modulanschluss (1) verbunden ist, der Drain-Anschluss (D) des zweiten elektronischen Schalters (T2) mit dem dritten Modulanschluss (3) verbunden ist und die Source-Anschlüsse (S) der elektronischen Schalter (T1, T2) miteinander und jeweils mit dem zweiten Modulanschluss (2) verbunden sind.

7. Verfahren nach Anspruch 5, wobei der Source-Anschluss (S) des ersten elektronischen Schalters (T1) mit dem ersten Modulanschluss (1) verbunden ist, der Source-Anschluss (S) des zweiten elektronischen Schalters (T2) mit dem dritten Modulanschluss (3) verbunden ist und die Drain-Anschlüsse (D) der elektronischen Schalter (T1, T2) miteinander und jeweils mit dem zweiten Modulanschluss (2) verbunden sind.

8. Verfahren nach einem der Ansprüche 1 bis 7, wobei antiparallel zu jedem elektronischen Schalter (T1, T2) eine Diode (D1, D2) geschaltet ist.

9. Verfahren nach einem der Ansprüche 1 bis 8, bei dem der erste Modulanschluss (1) und der dritte Modulanschluss (3) mittels eines Schalters (4) miteinander verbindbar sind.

## Claims

1. Method for connecting a load (L) to a DC network (N) by way of a switching module (M), the switching module (M) comprising a first module connection (1), a second module connection (2) and a third module connection (3), and
- a first electronic switch (T1) that is connected between the first module connection (1) and the second module connection (2), and
- a second electronic switch (T2) that is connected between the second module connection (2) and the third module connection (3), wherein
- the two electronic switches (T1, T2) are connected in anti-series between the first module connection (1) and the third module connection (3), wherein
- if bidirectional overcurrent protection against overcurrents in both current directions is required between the load (L) and the DC network (N), a network line (5) of the DC network (N) is connected to the first module connection (1) of the switching module (M) and a load line (6) of the load (L) is connected to the third module connection (3) of the switching module (M) and the second module connection (2) remains unconnected, and wherein
- if only unidirectional overcurrent protection against overcurrents in one current direction is required between the load (L) and the DC network (N), a network line (5) of the DC network (N) is connected to the first module connection (1) and/or the third module connection (3) of the switching module (M) and a load line (6) of the load (L) is connected to the second module connection (2) of the switching module (M).

2. Method according to Claim 1, wherein each electronic switch (T1, T2) is an insulated-gate bipolar transistor that has a collector connection (C), an emitter connection (E) and a gate connection (G).

3. Method according to Claim 2, wherein the collector connection (C) of the first electronic switch (T1) is connected to the first module connection (1), the collector connection (C) of the second electronic switch (T2) is connected to the third module connection (3) and the emitter connections (E) of the electronic switches (T1, T2) are connected to one another and each to the second module connection (2).

4. Method according to Claim 2, wherein the emitter connection (E) of the first electronic switch (T1) is connected to the first module connection (1), the emitter connection (E) of the second electronic switch (T2) is connected to the third module connection (3) and the collector connections (C) of the electronic switches (T1, T2) are connected to one another and each to the second module connection (2).

5. Method according to Claim 1, wherein each electronic switch (T1, T2) is a metal-oxide-semiconductor field-effect transistor that has a drain connection (D), a source connection (S) and a gate connection (G).

6. Method according to Claim 5, wherein the drain connection (D) of the first electronic switch (T1) is connected to the first module connection (1), the drain connection (D) of the second electronic switch (T2) is connected to the third module connection (3) and the source connections (S) of the electronic switches (T1, T2) are connected to one another and each to the second module connection (2).

7. Method according to Claim 5, wherein the source connection (S) of the first electronic switch (T1) is connected to the first module connection (1), the source connection (S) of the second electronic switch (T2) is connected to the third module connection (3) and the drain connections (D) of the electronic switches (T1, T2) are connected to one another and each to the second module connection (2).

8. Method according to one of Claims 1 to 7, wherein a diode (D1, D2) is connected in anti-parallel with each electronic switch (T1, T2).

9. Method according to one of Claims 1 to 8, wherein the first module connection (1) and the third module connection (3) are able to be connected to one another by way of a switch (4) .

## Revendications

1. Procédé de connexion d'une charge (L) à un réseau de courant continu (N) au moyen d'un module de commutation (M), le module de commutation (M) comprenant un premier raccordement de module (1), un deuxième raccordement de module (2) et un troisième raccordement de module (3), ainsi que
- un premier commutateur électronique (T1), qui est monté entre le premier raccordement de module (1) et le deuxième raccordement de module (2), et
- un deuxième commutateur électronique (T2) qui est monté entre le deuxième raccordement de module (2) et le troisième raccordement de module (3), dans lequel
- les deux commutateurs électroniques (T1, T2) sont montés en mode anti-série entre le premier raccordement de module (1) et le troisième raccordement de module (3),
- lorsqu'une protection bidirectionnelle contre les surintensités dans les deux directions de courant est nécessaire entre la charge (L) et le réseau de courant continu (N), une ligne de réseau (5) du réseau de courant continu (N) est reliée au premier raccordement de module (1) du module de commutation (M) et une ligne de charge (6) de la charge (L) est reliée au troisième raccordement de module (3) du module de commutation (M) et le deuxième raccordement de module (2) reste inactif,
et dans lequel
- lorsqu'entre la charge (L) et le réseau de courant continu (N), seule une protection unidirectionnelle contre les surintensités avec une direction de courant est nécessaire, une ligne de réseau (5) du réseau de courant continu (N) est reliée au premier raccordement de module (1) et/ou au troisième raccordement de module (3) du module de commutation (M) et une ligne de charge (6) de la charge (L) est reliée au deuxième raccordement de module (2) du module de commutation (M).

2. Procédé selon la revendication 1, dans lequel chaque commutateur électronique (T1, T2) est un transistor bipolaire à électrode de grille isolée qui présente un raccordement de collecteur (C), un raccordement d'émetteur (E) et un raccordement de grille (G).

3. Procédé selon la revendication 2, dans lequel le raccordement de collecteur (C) du premier commutateur électronique (T1) est relié au premier raccordement de module (1), le raccordement de collecteur (C) du second commutateur électronique (T2) est relié au troisième raccordement de module (3) et les raccordements d'émetteur (E) des commutateurs électroniques (T1, T2) sont reliés mutuellement et respectivement au deuxième raccordement de module (2).

4. Procédé selon la revendication 2, dans lequel le raccordement d'émetteur (E) du premier commutateur électronique (T1) est relié au premier raccordement de module (1), le raccordement d'émetteur (E) du second commutateur électronique (T2) est relié au troisième raccordement de module (3) et les raccordements de collecteur (C) des commutateurs électroniques (T1, T2) sont reliés mutuellement et respectivement au deuxième raccordement de module (2).

5. Procédé selon la revendication 1, dans lequel chaque commutateur électronique (T1, T2) est un transistor à effet de champ métal-oxyde-semiconducteur qui présente un raccordement de drain (D), un raccordement de source (S) et un raccordement de grille (G).

6. Procédé selon la revendication 5, dans lequel le raccordement de drain (D) du premier commutateur électronique (T1) est relié au premier raccordement de module (1), le raccordement de drain (D) du second commutateur électronique (T2) est relié au troisième raccordement de module (3) et les raccordements de source (S) des commutateurs électroniques (T1, T2) sont reliés mutuellement et respectivement au deuxième raccordement de module (2).

7. Procédé selon la revendication 5, dans lequel le raccordement de source (S) du premier commutateur électronique (T1) est relié au premier raccordement de module (1), le raccordement de source (S) du second commutateur électronique (T2) est relié au troisième raccordement de module (3) et les raccordements de drain (D) des commutateurs électroniques (T1, T2) sont reliés mutuellement et respectivement au deuxième raccordement de module (2).

8. Procédé selon l'une quelconque des revendications 1 à 7, dans lequel une diode (D1, D2) est relié en antiparallèle à chaque commutateur électronique (T1, T2).

9. Procédé selon l'une quelconque des revendications 1 à 8, dans lequel le premier raccordement de module (1) et le troisième raccordement de module (3) peuvent être reliés l'un à l'autre au moyen d'un commutateur (4).
